# EUROPEAN PATENT SPECIFICATION

(11) **EP 0 884 136 B1**
(45) Date of publication and mention of the grant of the patent: **05.11.2003**
(21) Application number: 98304444.7
(22) Date of filing: 04.06.1998
(51) Int. Cl.: B24B 37/04, B24B 49/04, B24B 49/12

(54) **Measuring method and apparatus for using the same**
Messverfahren und Messvorrichtung zur Durchführung des Verfahrens
Procédé de mesure et dispositif pour sa mise en oeuvre

(30) Priority: 10.06.1997 JP 16955797
(43) Date of publication of application: 16.12.1998
(73) Proprietor: CANON KABUSHIKI KAISHA, Tokyo (JP)
(72) Inventor: Nyui, Masaru, Ohta-ku, Tokyo (JP); Ban, Mikichi, Ohta-ku, Tokyo (JP)
(74) Representative: Beresford, Keith Denis Lewis

(56) References cited:
- EP-A- 0 663 265
- EP-A- 0 738 561
- EP-A- 0 806 266
- JP-A- 8 174 411
- US-A- 5 081 796
- US-A- 5 609 511

## Description

### BACKGROUND OF THE INVENTION

### Field of the Invention

This invention relates to an apparatus and method for measuring the thickness of a film layer provided on a surface of a substrate, as per the preamble of claims 1 and 12. An example of such an apparatus and method is disclosed by US 5 609 511 A.

### Related Background Art

In recent years, with the tendency of the semiconductor device toward higher integration, the tendency of circuit patterns toward minuteness and the tendency of the device structure toward three dimensions have been advancing. If the numerical aperture of a projection optical system is made great to achieve the higher integration of the semiconductor device, the depth of focus of the projection optical system correspondingly becomes shallow. Therefore, it is important to polish the surface of the semiconductor device to thereby remove any level difference portion and any uneven portion and flatten the surface, and apply photoresist onto the flattened surface, and projection-expose it to thereby achieve high resolution.

Also, it is an important factor for making the irregularity of the inter-layer capacity and the depth of via-holes constant to polish an insulating film layer provided on a silicon substrate to thereby provide a film layer of a uniform thickness.

A chemical-mechanical polishing method has heretofore been proposed as a flattening technique for removing the level difference portion and uneven portion of the surface of a semiconductor device to thereby flatten the surface.

In the chemical-mechanical polishing, it is necessary to appropriately control the polishing rate, the slurry density in polishing liquid and the temperature of a polishing surface in order to make the polishing efficient. If this control is defective, the insulating film provided on the silicon substrate will not assume a predetermined film thickness and the surface cannot be flattened and the aforementioned depth of focus cannot be secured and a reduction in the reliability of wiring will be caused and also, the dishing phenomenon and thinning phenomenon by the difference in polishing speed between the insulating film and an electrode wiring portion will occur to thereby cause short-circuiting or the like between via-holes.

Therefore, when the surface of a substrate such as a wafer having dielectric material layers or the like laminate is to be polished and flattened, it becomes important to appropriately judge the polishing terminating point and flatten the surface without removing the material of the lower layer.

For example, a terminating point detecting method of monitoring on the spot the film thickness of the surface of a substrate such as a wafer having dielectric material layers or the like laminate which is the object of polishing, and yet grasping the level of the flattening of the whole or localized part of the surface of the substrate such as the wafer and judging the optimum portion for terminating the polishing becomes important in the chemical-mechanical polishing.

As the method of detecting the polishing terminating point, use has heretofore been made, for example, of a method of obtaining the amount of polishing from the polishing time or a method of obtaining any change in polishing resistance from a change in the electric current of a polishing tool driving motor.

The method of obtaining the amount of polishing from the polishing time as a method of detecting the terminating point of polishing in the flattening of the surface of a semiconductor device by chemical-mechanical polishing requires to control conditions such as the pressing force of the semiconductor device, the degree of wear of a polishing pad, the density of slurry in polishing liquid and the temperature of a polishing surface constantly and therefore, it is difficult to detect the terminating point accurately.

Also, the method of obtaining any change in polishing resistance from a change in the electric current of a polishing tool driving motor requires to separate a signal waveform and noise from each other highly accurately and therefore, it is difficult to detect the terminating point accurately.

United States Patent No. 5,609,511 discloses a method and apparatus for measuring a film thickness on a surface of a substrate in circumstances in which the film is to be polished to a predetermined thickness. The position of the front surface of the film to be polished is detected using a first sensor, and the position of the bottom surface of the film layer, at its interface with the substrate, is detected using a second sensor. The residual thickness of the film is calculated on the basis of the detected front and bottom positions.

### SUMMARY OF THE INVENTION

The present invention has as its first object the provision of an apparatus and method to solve the above mentioned problems. This object is achieved by an apparatus as per claim 1 and a method as per claim 12.

Other objects of the present invention will become apparent from the following detailed description of some embodiments of the invention.

### BRIEF DESCRIPTION OF THE DRAWINGS

Fig. 1 is a schematic view of the principal portions of Embodiment 1 of the polishing apparatus of the present invention.
Fig. 2 is a schematic view of the principal portions of film thickness measuring means in Embodiment 1 of the polishing apparatus of the present invention.
Fig. 3 is a schematic view of the principal portions of film thickness measuring means in Embodiment 2 of the polishing apparatus of the present invention.
Fig. 4 shows that in the film thickness measuring means in Embodiment 2 of the polishing apparatus of the present invention, the film thickness difference is represented as the distribution of an interference color.
Fig. 5 is a flow chart of the operation in the film thickness measuring means in Embodiment 1 of the polishing apparatus of the present invention.

### DESCRIPTION OF THE PREFERRED EMBODIMENTS

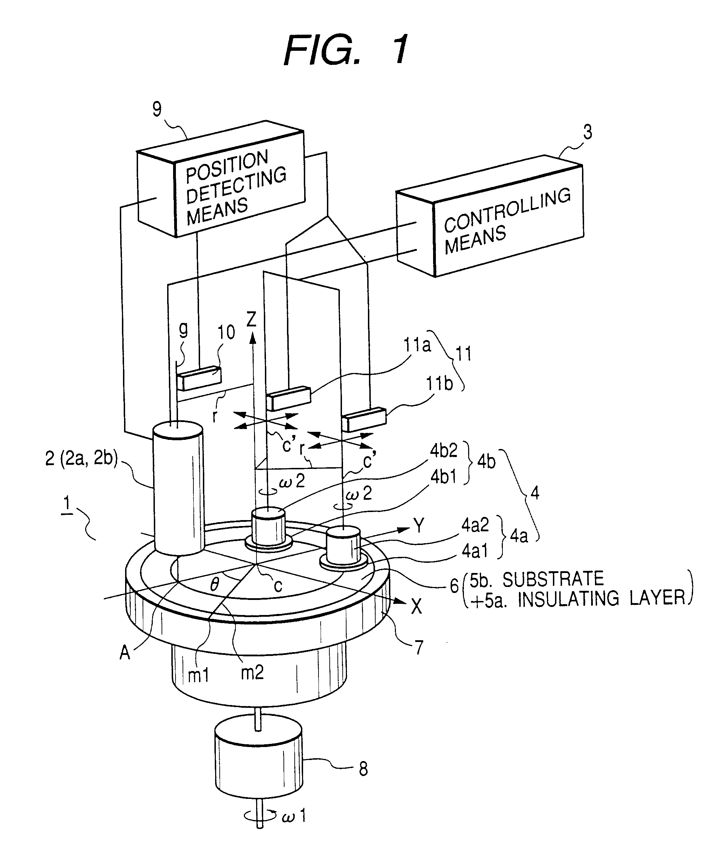

Fig. 1 is a schematic view of the principal portions of Embodiment 1 of the polishing apparatus (chemical-mechanical polishing apparatus) of the present invention, and shows a state in which an insulating film layer 5a on a substrate 5b which is a workpiece 6 is being polished by polishing means 4.

In Fig. 1, the reference numeral 2 designates film thickness measuring means. The film thickness measuring means 2 according to the present embodiment which will hereinafter be described comprises at least one of first film thickness measuring means 2a for measuring the absolute value of the film thickness at a position A on the insulating film layer 5a on the substrate 5b and second film thickness measuring means 2b for measuring film thickness information such as the film thickness difference in an area B around the position A with the absolute value of the film thickness at the position A as the reference and the average value of the film thickness.

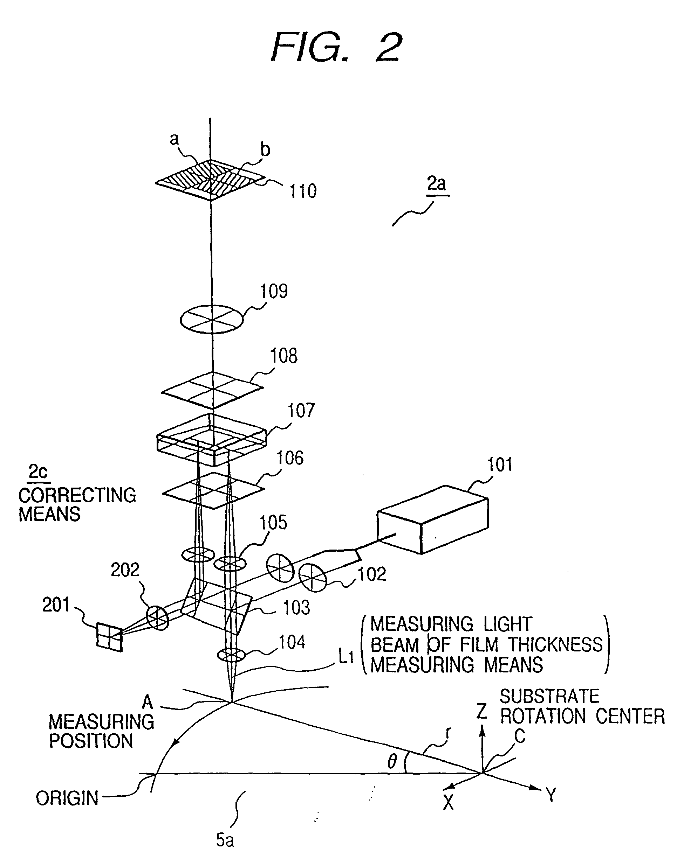

In Embodiment 1 shown in Fig. 2, there is shown a case where the first film thickness measuring means 2a is used as the film thickness measuring means 2.

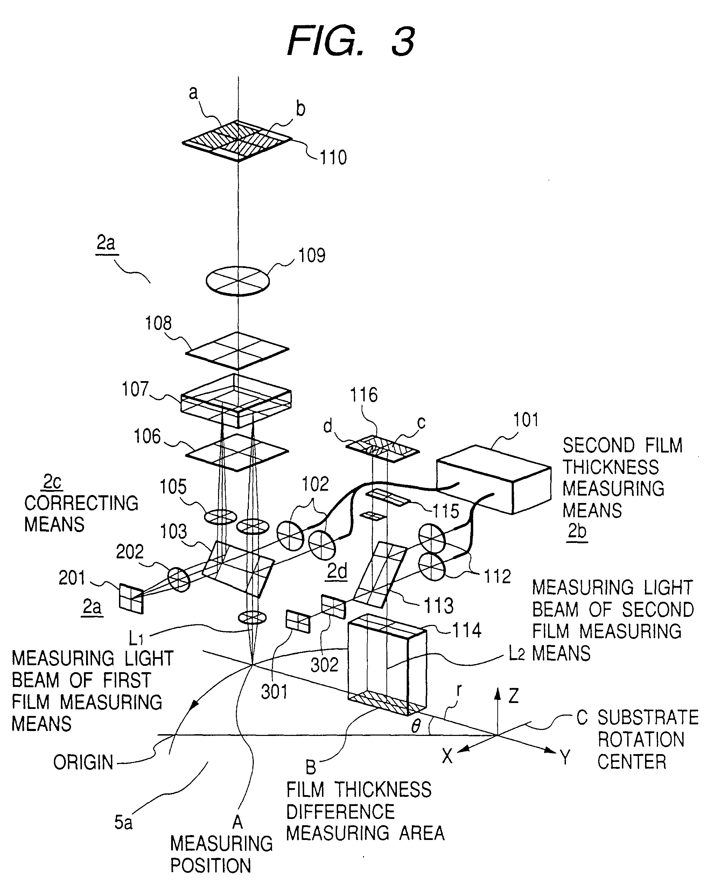

In Embodiment 3 shown in Fig. 3, there is shown a case where the first film thickness measuring means 2a and the second film thickness measuring means 2b are used as the film thickness measuring means 2.

Fig. 2 shows a state in which the absolute value of the film thickness at a predetermined measuring position A on the insulating film surface 5a is being measured by the first film thickness measuring means 2a by the utilization of momentary light such as flashlight.

In Fig. 1, the reference numeral 1 denotes the chemical-mechanical polishing apparatus. Fig. 1 shows the manner in which the surface (substrate surface) of the workpiece 6 is polished by two partial polishing tools (polishing means) 4. The workpiece 6 comprises a construction in which an insulating film layer (film layer) 5a is formed on a silicon substrate 5b, and is held by a substrate holder 7. The substrate holder 7 holds the workpiece 6 and is rotated at an angular velocity ω1 about a rotary shaft C by driving means (not shown).

In Fig. 1, the rotary shaft C is defined as the Z-axis and a plane orthogonal thereto is defined as X, Y plane. The reference numeral 8 designates a rotary encoder which detects the rotation information of the rotary shaft C. The reference numeral 2 denotes the film thickness measuring means which comprises a construction shown in Fig. 2 and which measures the absolute value of the film thickness at the predetermined position A on the insulating film layer 5a on the substrate 5b by the first film thickness measuring means 2a.

The reference numeral 3 designates controlling means which controls the terminating point of the polishing step for the workpiece 6 or whether the polishing step should be continued, on the basis of the result of the detection of the surface information of the workpiece 6.

The reference numeral 4 (4a, 4b) denotes a partial polishing tool (polishing means). The partial polishing tool has a polishing pad (4a1) and a holder (4a2) for holding the polishing pad (4a1), and is rotated at an angular velocity ω2 about a rotary shaft C' by driving means (not shown).

In Fig. 1, there is shown a case where the insulating film layer 5a on the silicon substrate 5b is partially polished by the two partial polishing tools 4a and 4b. More than two partial polishing tools 4 may be used.

In the present embodiment, as shown, the polishing opening in the polishing pad (4a1) is smaller than the polished surface (insulating film layer) 5a of the workpiece 6. Thereby, partial polishing is effected. The partial polishing tool 4 (4a, 4b) is at a predetermined distance in the X-axis direction from the Z-axis as shown, and is movable by a predetermined distance on the X-axis.

In the present embodiment, a scrubber (not shown) is provided to thereby eliminate slurry or the like adhering to the insulating film layer 5a when the film thickness is measured.

Also, a water supply nozzle (not shown) for the supply of pure water is provided to thereby discharge the pure water to the surface to be worked (the insulating film layer) 5a and eliminate any slurry, dust, etc. adhering thereto, thus facilitating the highly accurate detection of the film thickness of the workpiece by the film thickness measuring means 2. The reference numeral 9 designates position detecting means which measures the position information on the insulating film layer 5a. The reference numeral 10 denotes a linear encoder, and the reference numeral 11 (11a, 11b) designates a two-axis linear encoder.

In the present embodiment, when the surface of the insulating film layer 5a is to be polished, the partial polishing tool 4 is rotated about the rotary shaft C' and is rotated about the rotary shaft C of the substrate holder 7 and both of them are driven relative to each other, and the slurry including a polishing material is caused to flow out from a nozzle (not shown) onto the surface of the workpiece 6 while the relative positive of both in X direction and Y direction is displaced as required, and the slurry is uniformly supplied to the interface between the insulating film layer 5a and the polishing pad.

At this time, polishing is effected with the pressure between the insulating film layer 5a and the partial polishing tool 4, the ratio of the number of revolutions therebetween and the amount of slurry supplied appropriately selected. Thereby, the insulating film layer 5a formed on the silicon substrate 5b is partially polished by the partial polishing tool 4 to thereby achieve the flattening of the surface thereof.

After partial polishing is effected for a preset time, the absolute value of the film thickness at the position A on the insulating film layer 5a is measured by the first film thickness measuring means 2a shown in Fig. 2 by the use of a method which will be described later.

In the present embodiment, design is made such that the film thickness information of the insulating film layer 5a of the workpiece 6 can be measured by utilizing momentary light even when that layer is being polished, thereby achieving an improvement in throughput.

On the basis of an output signal obtained from the film thickness measuring means 2a, the film thickness of the insulating film layer 5a is found by the controlling means 3. At this time, the controlling means 3 judges whether the film thickness of the insulating film layer 5a at a predetermined position is within a preset range.

When the film thickness is within the present range, the controlling means judges that polishing is at the terminating point, and stops the polishing step. When not so, the controlling means controls so as to continue the polishing step again. The controlling means 3 stops the polishing step when it judges during the polishing step that the film thickness of the insulating film layer 5a at the predetermined position is not within the preset range (for example, when the insulating film layer has been polished too much and has become too thin). At this time, the controlling means judges that the workpiece 6 is a substandard article.

The specific construction and operation of the present embodiment will now be described in succession.

Description will first be made of a detecting method (position detecting step) for positional information as to what position on the insulating film layer 5a is being measured by the film thickness measuring means 2a.
(a1) About the detecting method for the predetermined position A
   (a1-1) When the substrate 5b is to be mounted on and held by the substrate holder 7, the reference mark m1 of the substrate holder 7 and a mark m2 formed on the substrate 5b are brought into coincidence with each other. The position of this mark m1 corresponds to the origin position of the rotary encoder 8 connected to the substrate holder 7.
   (a1-2) Let it be assumed that the predetermined position A on the substrate 5b at which the film thickness is measured is at an angle θ from this origin position and at a distance r from the center of rotation C of the substrate 5b.
   (a1-3) The position detecting means 9 confirms this position A, and controls the measurement reference axis g of the first film thickness measuring means 2a by the use of the linear encoder 10 so as to become the position at the distance r from the center of rotation C of the substrate 5b.
   (a1-4) Film thickness measurement is commanded at a position whereat the output of the rotary encoder 8 becomes θ.

The first film thickness measuring means 2a in the present embodiment uses momentary light to measure the absolute value of the film thickness at the predetermined position A on the workpiece 6 which is being rotated.

Description will now be made of a measuring method for the absolute value of the film thickness at the measuring position by the first film thickness measuring means 2a.
(a2) About the film thickness measuring method of the first film thickness measuring means 2a
   (a2-1) During the film thickness measurement, pure water or the like is discharged by a nozzle to the insulating film layer 5a on the substrate 5b which is the workpiece, and eliminates any slurry, dust, etc. adhering thereto, and then the film thickness is measured.
   (a2-2) The first film thickness measuring means 2a uses a white interference system. White light emitted from a momentary light source (first light source) 101 emitting momentary light such as flashlight is condensed and applied as a measurement light beam L1 to a particular measuring position A on the insulating film layer 5a via a condenser lens 102, a half mirror (HM) 103 and an objective lens 104.
   (a2-3) The reflected light beam from the measuring position A enters a Wallaston prism 107 as a double-refractive prism through the objective lens 104, the half mirror (HM) 103, an imaging lens 105 and a polarizing filter 106, and is separated into P- and S-polarized waves and is tilted, and enters a CCD camera 110 through a polarizing filter 108 and a relay lens 109.

The relation between the output signal from the CCD camera (first light receiving element) 110 at this time and the film thickness at the measuring position A is as follows. Two light beams reflected by the surface of the insulating film layer 5a and the boundary surface between the insulating film layer 5a and the substrate 5b are separated into P- and S-polarized lights and the wave fronts thereof are tilted in discrete directions by the Wallaston prism 107, and the interval between interference fringes created on the portion of the line of intersection between the wave front of the P-polarized light reflected from the surface and the wave front of the S-polarized light reflected from the boundary surface, or the portion of the line of intersection between the wave front of the S-polarized light reflected from the surface and the wave front of the P-polarized light reflected from the boundary surface is found by calculating the peak-to-peak distance of the distribution of the quantity of light on the CCD camera 110 from the number of elements to thereby measure the absolute film thickness value.

The absolute film thickness value d is d = y × sin a/n when the peak interval is y and the refractive index of the material of the film layer 5a is n and the tilt angle of the wave fronts of the P-polarized light and S-polarized light by the Wallaston prism is a.

In the present embodiment, at the position detecting step, momentary light is applied to the measuring position A in synchronism with a position at which the output from the rotary encoder 8 becomes an angle θ. Thereby, the film thickness measurement at the measuring position A is effected. By such a film thickness measuring method, highly accurate measurement is effected in such a manner that even if the measuring position A moves during the polishing of the surface of the film layer 5a, the momentary light is not applied to the outside of the range of the measuring position A.

Also, correcting means 2c for correcting the measured film thickness value is provided on the first film thickness measuring means 2a, and the correcting means 2c contains therein a sample 201 for correction of which the film thickness is known, and uses in common at least the momentary light source 101 of the first film thickness measuring means 2a and the light receiving element (CCD camera) 110 to effect the film thickness measurement and the measurement for correction in synchronism with each other.

That is, the light beam from the momentary light source 101 is caused to enter the sample 201 for correction through the condenser lens 102, the half mirror 103 and a lens 202 in succession. Then, the light beam from the sample 201 for correction is caused to enter the area b of the CCD camera 110 through the lens 202, the half mirror 103, the imaging lens 105, the polarizing filter 106, the Wallaston prism 107, the polarizing filter 108 and the lens 109 in succession.

As described above, on the CCD camera 110, the light receiving element of the film thickness measuring system uses an area a, and the correcting system uses the area b.

The film thickness measuring method of this correcting means 2c adopts the same method as that of the film thickness measuring system. When the result of the measurement by the first film thickness measuring means 2a is to be corrected on the basis of the result of the measurement by this correcting means, the influence of the slurry or the like of polishing adhering to the sample 201 for correction to thereby deteriorate the accuracy of correction is prevented by the correcting means containing the sample 201 for correction therein, as compared with a case where the sample for correction is externally attached to the periphery of the workpiece 6 held by the substrate holder 7, and also the time for the first film thickness measuring means 2a to be moved to the location of the sample for correction during correction is omitted. Also, the momentary light source 101 and the light receiving element (CCD camera) 110 of the first film thickness measuring means 2a are used in common and the film thickness measurement and the measurement of correction are effected in synchronism with each other, whereby as compared with a case where they are effected independently of each other, the measurement error by a change or the like in the level of a dark current attributable to the light receiving element and the correction error when a change in the spectral distribution and the light emission intensity of the momentary light source occurs are reduced to the utmost.

Description will now be made of the film thickness measuring means 2 according to the Fig. 3 embodiment of the present invention. In this embodiment, there is shown a case where the absolute film thickness value at the measuring position A is measured by first film thickness measuring means 2a and with the absolute film thickness value at this measuring position A as the reference, film thickness information such as the film thickness difference in the surrounding area B is measured by second film thickness measuring means 2b utilizing the momentary light.

In Fig. 3, the film thickness measuring method of the first film thickness measuring means 2a is the same as that of the first film thickness measuring means 2a of Fig. 2.

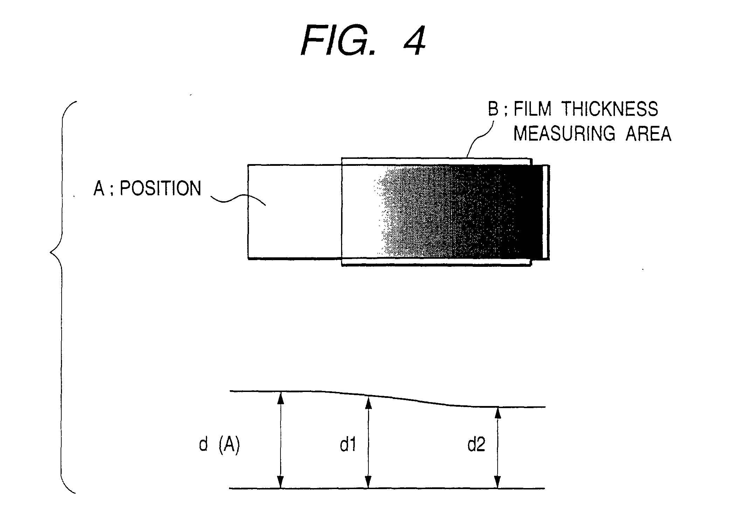

Here, description will be made of a method of measuring the film thickness difference from the absolute film thickness value at the measuring position in the area B around the measuring position A by the second film thickness measuring means 2b.
(a3) About the film thickness measuring method of the second film thickness measuring means 2b
   (a3-1) A film thickness difference measuring area B for measuring what degree of difference the surroundings of the position A at which the absolute film thickness value has been measured have from that absolute film thickness value is set.
   (a3-2) The second film thickness measuring means 2b has an optical system for reducing and projecting this film thickness difference measuring area B onto a color CCD 116. First, white light (momentary light) emitted from a momentary light source 101 as a second light source which is the same as the first light source is applied as a measurement light beam L2 to the film thickness difference measuring area B of the insulating film layer 5a via a condenser lens 112, a half mirror (HM) 113 and an objective lens 114. The reflected light beam from the film thickness difference measuring area B is reduced and projected onto the color CCD (second light receiving element) 116 via the objective lens 114, the half mirror (HM) 113 and a lens 115.
   (a3-3) When that area is defined as c, the interior of the area c presents an interference color conforming to the film thickness difference with respect to the absolute film thickness value d(A) at the position A as will be described next. In Fig. 4, what is a wavelength λA which strengthens by interference when the film thickness is d(A) is found by the calculation of the following expression, and the interference color at the position A is determined:$\text{2nAd(A) = NλA (N being an integer)}$
   (a3-4) Assuming that the distribution of the interference color in an area c is λ1 to λ 2 in terms of the expression of wavelength, as compared with the result of the absolute film thickness value d(A), the distribution d1 to d2 of the film thickness difference in the area c is calculated from$\text{d1 = Nλ1/2n1}$$\text{d2 = Nλ2/2n2.}$

In the present embodiment, at the position detecting step, the momentary light is applied to the measuring area B in synchronism with a position at which the output from the rotary encoder 8 becomes an angle θ. Thereby, the film thickness measurement in the measuring area B is effected. By such a film thickness measuring method, highly accurate measurement is effected in such a manner that even if the measuring area B is moving during the polishing of the surface of the film layer 5a, the momentary light is not applied to the outside of the range of the measuring area B.

As described above, the present embodiment has the film thickness distribution measuring step of providing one or more of the first and second film thickness measuring means 2a and 2b, measuring the absolute value of the film thickness and the film thickness difference, and obtaining the film thickness distribution of the insulating film layer 5a of the whole of the substrate 5b.

In the present embodiment, as in Embodiment 1, correcting means 2d for correcting the measured value of the film thickness is provided on the second film thickness measuring means 2b, and the correction means 2d contains therein a sample 301 for correcting of which the film thickness is known, and uses in common the momentary light source 101 and the light receiving element (color CCD camera) 116 of the second film thickness measuring means 2b to effect the measurement by the second film thickness measuring means 2b and the measurement of the correction in synchronism with each other.

On the color CCD camera 116, the light receiving element of the second film thickness measuring means 2b uses an area c and the correcting system uses an area d.

The film thickness measuring method of this correcting means 2d adopts the same method as that of the second film thickness measuring means 2b.

When the result of the measurement by the second film thickness measuring means 2b is to be corrected on the basis of the result of the measurement by this correcting means 2d, the influence of the slurry or the like of polishing adhering to the sample for correction to thereby deteriorate the accuracy of correction is prevented by the correcting means containing the sample 301 for correction therein, as compared with a case where the sample for correction is externally attached to the periphery of the workpiece 6 held by the substrate holder 7, and also the time for the second film thickness measuring means 2b to be moved to the location of the sample 301 for correction during correction can be omitted. Also, the momentary light source 101 and the light receiving element (color CCD camera) 116 of the second film thickness measuring means 2b are used in common and the second film thickness measurement and the measurement of correction are effected in synchronism with each other, whereby as compared with a case where they are effected independently of each other, the measurement error by a change or the like in the level of a dark current attributable to the light receiving element and the correction error when a change in the spectral distribution and the light emission intensity of the momentary light source occurs are reduced to the utmost.

Besides the measuring method of the first and second film thickness measuring means 2a and 2b described above, when the workpiece is one simple in film layer structure like a monitor wafer, use can also be made of a method using a momentary light beam of a particular wavelength selected from a semiconductor laser or a white light source, using a photosensor as the light receiving element of the first film thickness measuring means, and using a black-and-white CCD camera as the light receiving element of the second film thickness measuring means.

In such case, with the signal output from the photosensor of the first film thickness measuring means as the reference, the distribution of the signal output of the black-and-white CCD camera in the second film thickness measuring means corresponding to the aforementioned film thickness difference measuring area B is compared to thereby calculate any change in the film thickness of the workpiece.

Description will now be made of the control of the polishing step in the present embodiment.
(a4) About the control of the polishing means and polishing conditions.
   (a4-1) By the use of a linear encoder 11 for two axes from the position detecting means 9, the polishing means (partial polishing tool) 4 is moved to a position at a distance r from the Z-axis. This polishing means 4 is rockable about the X-axis and the Y-axis while being rotated.
   (a4-2) On the basis of the information from the first and second film thickness measuring means 2a and 2b, the difference from the film thickness distribution which is the final target is compared, and when the difference is not within the range of a predetermined value, the polishing conditions are corrected by the value of the difference and the polishing means 4 is controlled so as to re-polish.
   (a4-3) When this difference comes into the range of the predetermined value, the polishing work is stopped.

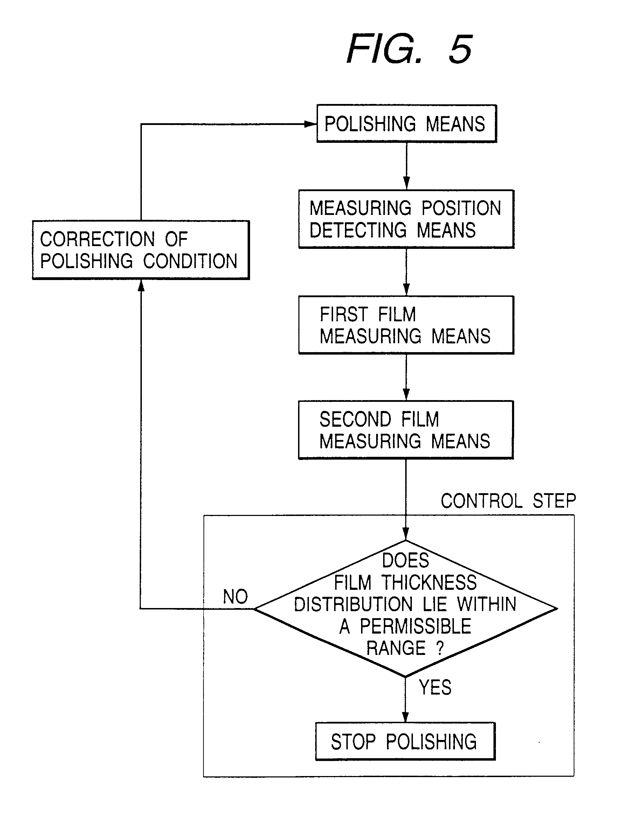

Fig. 5 shows a flow chart of the operations of the various means in the present embodiment.

As described above, in the present embodiment, the insulating film layer 5a of the silicon substrate 5b is polished and flattened by the polishing means, whereby the whole of the area of the insulating film layer 5a which is the object when projected and exposed comes into the depth of focus of the projection optical system. Also, the irregularity of the inter-layer capacity is prevented in such a manner that the film thickness of the insulating film layer 5a is within a predetermined range, and the depths of via-holes are unified.

## Claims

1. An apparatus for measuring a film thickness of a film layer (5a) provided on a surface of a substrate (5b), comprising:
a position detecting system (8, 9, 10, 11) for detecting a predetermined position (A) on a surface of said film layer; and
a first measuring system (2a) having a light source (101) emitting a momentary light and a light receiving element (110), said first measuring system applying the momentary light from said light source to said predetermined position on the basis of detection by said position detecting system, and detecting the light beam from said predetermined position by said light receiving element to thereby measure a film thickness at said predetermined position;
**characterised in that** said light receiving element (110) detects a first reflection from said surface of said film layer (5a) and detects a second reflection from a boundary surface between said film layer (5a) and said substrate (5b), whereby the film thickness at said predetermined position (A) is obtained from interference fringes formed by said first and second reflections.

2. An apparatus for polishing a surface of a film layer (5a) provided on a surface of a substrate (5b) by using the apparatus of claim 1, comprising:
polishing means (4) driven relative to said substrate to thereby polish; and
a controlling system (3) for controlling said polishing means by using data obtained by said first measuring system.

3. An apparatus according to claim 2, wherein said first measuring system (2a) has correcting means (2c) for correcting a value of said measured film thickness, and said correcting means performs measurement of a film thickness of a sample for correction of which the film thickness is known executed by using said first light source and said first light receiving element and in synchronism with measurement of the film thickness at said predetermined position.

4. An apparatus according to claim 2, wherein said controlling system stops polishing when at least one of said film thickness and said film thickness distribution of said film layer comes into a preset range.

5. An apparatus according to claim 2, wherein operations of said first measuring system and said controlling system are performed during polishing of a surface of said film surface by said polishing means.

6. An apparatus according to claim 2, further comprising:
a second measuring system (2b) having a second light source (101) emitting a momentary light and a second light receiving element (116), said second measuring system applying said momentary light from said second light source to an area (B) including or adjacent to said predetermined position, and detecting the light beam from said area by said second light receiving element to thereby measure a film thickness information of said area;
a film thickness distribution measuring portion for obtaining a film thickness distribution of said film layer by using results of measurement obtained by said first measuring system and said second measuring system;
wherein said controlling system controls whether or not polishing by said polishing means should be continued based on data obtained by said film thickness distribution measuring portion.

7. An apparatus according to claim 6, wherein at least one of said first measuring system (2a) and said second measuring system (2b) has correcting means (2c, 2d) for correcting a value of said measured film thickness, and said correcting means has the measurement of the film thickness of a sample for correction of which the film thickness has been known executed by using said light source and said light receiving element of said at least one measuring system and in synchronism with the measurement of the film thickness by said at least one measuring system.

8. An apparatus according to claim 6, wherein said film thickness information measured by said second measuring system (2b) is a film thickness difference or an average value of the film thickness.

9. An apparatus according to claim 6, wherein said controlling system (3) stops polishing when the film thickness distribution of said film layer comes into a preset range.

10. An apparatus according to claim 6, wherein operations of said first (2a) and second measuring systems (2b), said film thickness distribution measuring portion and said controlling system (3) are performed during polishing of surface of said film layer (5a) by said polishing means (4).

11. An apparatus according to claim 6, wherein a common light source (101) is provided as said light source (101) and as said second light source (101).

12. A polishing method for polishing a surface of a film layer provided on a surface of a substrate by polishing means driven relative to the substrate, comprising:
a position detecting step of detecting a predetermined position on a surface of said film layer;
a first measuring step of applying a momentary light from a first light source to said predetermined position, and detecting a light beam from said predetermined position by a first light receiving element to thereby measure a film thickness at said predetermined position; and
a controlling step of controlling a polishing condition by using data obtained at said first measuring step;
**characterised in that** said first measuring step comprises causing said light receiving element (110) to detect a first reflection from said surface of said film layer (5a) and to detect a second reflection from a boundary surface between said film layer (5a) and said substrate (5b), and obtaining the film thickness at said predetermined position (A) from interference fringes formed by said first and second reflections.

13. A method according to claim 12, wherein said first measuring step has a correcting step for correcting a value of the measured film thickness, and said correcting step performs measurement of the film thickness of a sample for correction of which the film thickness has been known executed by using said first light source and said first light receiving element used at said first measuring step and in synchronism with said first measuring step.

14. A method according to claim 12, wherein said controlling step stops polishing when at least one of the film thickness and the film thickness distribution of said film layer comes into a preset range.

15. A method according to claim 12, wherein operations of said first measuring step and said controlling step are performed during polishing of surface of said film layer by said polishing means.

16. A method according to claim 12, further comprising:
a second measuring step of applying a momentary light from a second light source to an area including or adjacent to said predetermined position, and detecting the light beam from said area by a second light receiving element to thereby measure a film thickness information of said area; and
a film thickness distribution measuring step of obtaining a film thickness distribution of said film layer by using results of measurement obtained at said first measuring step and said second measuring step;
wherein said controlling step controls whether or not said polishing should be continued, from data obtained at said film thickness distribution measuring step.

17. A method according to claim 16, wherein at least one of said first measuring step and said second measuring step has a correcting step for correcting a value of the measured film thickness, and said correcting step performs measurement of a film thickness of a sample for correction of which the film thickness has been known executed by using said light source and said light receiving element used at said at least one measuring step and in synchronism with said at least one measuring step.

18. A method according to claim 16, wherein said film thickness information measured at said second measuring step is a film thickness difference or an average value of said film thickness.

19. A method according to claim 16, wherein said controlling step stops polishing when the film thickness distribution of said film layer comes into a preset range.

20. A method according to claim 16, wherein operations of said first and second measuring steps, said film thickness distribution measuring step and said controlling step are performed during polishing of surface of said film layer by said polishing means.

21. A method according to claim 16, wherein a common light source is used as said light source and as said second light source.

## Patentansprüche

1. Vorrichtung zur Messung einer Filmdicke einer Filmschicht (5a), die auf einer Oberfläche eines Substrats (5b) vorgesehen ist, mit
einem Positionserfassungssystem (8, 9, 10, 11) zur Erfassung einer vorbestimmten Position (A) auf einer Oberfläche der Filmschicht, und
einem ersten Messungssystem (2a) mit einer Lichtquelle (101), die ein momentanes Licht emittiert, und einem Lichtempfangselement (10), wobei das erste Messungssystem das momentane Licht aus der Lichtquelle auf die vorbestimmte Position auf der Grundlage einer Erfassung durch das Positionserfassungssystem beaufschlagt, und den Lichtstrahl von der vorbestimmten Position durch das Lichtempfangselement erfasst, um dadurch eine Filmdicke an der vorbestimmten Position zu erfassen,
**dadurch gekennzeichnet, dass** das Lichtempfangselement (110) eine erste Reflexion von der Oberfläche der Filmschicht (5a) erfasst und eine zweite Reflexion von einer Grenzoberfläche zwischen der Filmschicht (5a) und dem Substrat (5b) erfasst, wodurch die Filmdicke an der vorbestimmten Position (A) anhand von Interferenzmustern erhalten wird, die durch die ersten und zweiten Reflexionen gebildet werden.

2. Vorrichtung zum Polieren einer Oberfläche einer Filmschicht (5a), die auf einer Oberfläche eines Substrats (5b) vorgesehen ist, unter Verwendung der Vorrichtung nach Anspruch 1, mit
einer Poliereinrichtung (4), die relativ zu dem Substrat angetrieben wird, um dadurch zu polieren, und
einem Steuerungssystem (3) zur Steuerung der Poliereinrichtung unter Verwendung von Daten, die durch das erste Messungssystem erhalten werden.

3. Vorrichtung nach Anspruch 2, wobei das erste Messungssystem (2a) eine Korrektureinrichtung (2c) zur Korrektur eines Werts der gemessenen Filmdicke aufweist, und die Korrektureinrichtung eine Messung einer Filmdicke eines Musters zur Korrektur durchführt, dessen Filmdicke bekannt ist, die unter Verwendung der ersten Lichtquelle und des ersten Lichtempfangselement durchgeführt wird und synchron mit der Messung der Filmdicke an der vorbestimmten Position durchgeführt wird.

4. Vorrichtung nach Anspruch 2, wobei das Steuerungssystem das Polieren stoppt, wenn zumindest entweder die Filmdicke oder die Filmdickenverteilung der Filmschicht in einen vorab eingestellten Bereich gelangt.

5. Vorrichtung nach Anspruch 2, wobei Vorgänge des ersten Messungssystems und des Steuerungssystems während des Polierens einer Oberfläche der Filmoberfläche durch die Poliereinrichtung durchgeführt werden.

6. Vorrichtung nach Anspruch 2, weiterhin mit
einem zweiten Messungssystem (2b) mit einer zweiten Lichtquelle (101), die ein momentanes Licht emittiert, und einem zweiten Lichtempfangselement (116), wobei das zweite Messungssystem das momentane Licht aus der zweiten Lichtquelle auf einen Bereich (B) beaufschlagt, der die vorbestimmte Position einschließt oder dieser benachbart ist, und durch das zweite Lichtempfangselement den Lichtstrahl aus dem Bereich erfasst, um dadurch eine Filmdickeninformation des Bereichs zu messen,
einem Filmdickenverteilungs-Messungsabschnitt zum Erhalt einer Filmdickenverteilung der Filmschicht unter Verwendung von Ergebnissen von Messungen, die durch das erste Messungssystem und das zweite Messungssystem erhalten werden,
wobei das Steuerungssystem auf der Grundlage von durch den Filmdickenverteilungs-Messungsabschnitt erhaltenen Daten steuert, ob ein Polieren durch die Poliereinrichtung fortgesetzt werden sollte oder nicht.

7. Vorrichtung nach Anspruch 6, wobei zumindest entweder das erste Messungssystem (2a) oder das zweite Messungssystem (2b) eine Korrektureinrichtung (2c, 2d) zur Korrektur eines Werts der gemessenen Filmdicke aufweist, und die Korrektureinrichtung die Messung der Filmdicke eines Musters zur Korrektur aufweist, dessen Filmdicke bekannt ist, die unter Verwendung der Lichtquelle und des Lichtempfangselements von zumindest einem Messungssystem und synchron mit der Messung der Filmdicke durch das zumindest eine Messungssystem ausgeführt wird.

8. Vorrichtung nach Anspruch 6, wobei die durch das zweite Messungssystem (2b) gemessenen Filmdickeninformation eine Filmdickendifferenz oder ein Durchschnittswert der Filmdicke ist.

9. Vorrichtung nach Anspruch 6, wobei das Steuerungssystem (3) ein Polieren stoppt, wenn die Filmdickenverteilung der Filmschicht in einen vorab eingestellten Bereich gelangt.

10. Vorrichtung nach Anspruch 6, wobei Vorgänge des ersten Messungssystems (2a) und des zweiten Messungssystems (2b), des Filmdickenverteilungs-Messungsabschnitts sowie des Steuerungssystems (3) während einer Polierens einer Oberfläche der Filmschicht (5a) durch die Poliereinrichtung (4) durchgeführt werden.

11. Vorrichtung nach Anspruch 6, wobei eine gemeinsame Lichtquelle (101) als die Lichtquelle (101) und als die zweite Lichtquelle (101) verwendet wird.

12. Polierverfahren zum Polieren einer Oberfläche einer Filmsicht, die auf einer Oberfläche eines Substrats vorgesehen ist, durch eine Poliereinrichtung, die relativ zu dem Substrat angetrieben wird, mit
einem Positionserfassungsschritt des Erfassens einer vorbestimmten Position auf einer Oberfläche der Filmschicht,
einem ersten Messungsschritt des Beaufschlagens von momentanem Licht aus einer ersten Lichtquelle auf die vorbestimmte Position und Erfassens eines Lichtstrahls von der vorbestimmten Position durch ein erstes Lichtempfangselement, um dadurch eine Filmdicke an der vorbestimmten Position zu erfassen, und
einem Steuerungsschritt des Steuerns eines Polierzustands unter Verwendung von in dem ersten Messungsschritt erhaltenen Daten,
**dadurch gekennzeichnet, dass** der erste Lichtmessungsschritt aufweist: Bewirken, dass das erste Lichtempfangselement (110) eine erste Reflexion von der Oberfläche der Filmschicht (5a) erfasst und eine zweite Reflexion von einer Grenzoberfläche zwischen der Filmschicht (5a) und dem Substrat (5b) erfasst, und Erhalten der Filmdicke an der vorbestimmten Position (A) anhand von Interferenzmustern, die durch die ersten und zweiten Reflexionen gebildet werden.

13. Verfahren nach Anspruch 12, wobei der Messungsschritt einen Korrekturschritt zur Korrektur eines Wertes der gemessenen Filmdicke aufweist, und der Korrekturschritt eine Messung der Filmdicke eines Musters zur Korrektur durchführt, dessen Filmdicke bekannt ist, die unter Verwendung der ersten Lichtquelle und des ersten Lichtempfangselement, die in dem ersten Messungsschritt verwendet werden, und synchron mit dem ersten Messungsschritt ausgeführt wird.

14. Verfahren nach Anspruch 12, wobei das Steuerungsschritt das Polieren stoppt, wenn zumindest entweder die Filmdicke oder die Filmdickenverteilung der Filmschicht in einen vorab eingestellten Bereich gelangt.

15. Verfahren nach Anspruch 12, wobei Vorgänge des ersten Messungsschritts und des Steuerungsschritts während des Polierens einer Oberfläche der Filmoberfläche durch die Poliereinrichtung durchgeführt werden.

16. Verfahren nach Anspruch 12, weiterhin mit
einem zweiten Messungsschritt des Beaufschlagens von momentanem Licht aus einer zweiten Lichtquelle auf einen Bereich, der die vorbestimmte Position einschließt oder dieser benachbart ist, und Erfassens des Lichtstrahls von dem Bereich durch ein zweites Lichtempfangselement, um dadurch eine Filmdickeninformation des Bereichs zu messen,
einem Filmdickenverteilungs-Messungsabschnitt des Erhaltens einer Filmdickenverteilung der Filmschicht unter Verwendung von Ergebnissen von Messungen, die in dem ersten Messungsschritt und dem zweiten Messungsschritt durchgeführt werden,
wobei das Steuerungsschritt auf der Grundlage von durch den Filmdickenverteilungs-Messungsabschnitt erhaltenen Daten steuert, ob das Polieren fortgesetzt werden sollte oder nicht.

17. Verfahren nach Anspruch 16, wobei zumindest entweder der erste Messungsschritt oder der zweite Messungsschritt einen Korrekturschritt zur Korrektur eines Werts der gemessenen Filmdicke aufweist, und der Korrekturschritt eine Messung der Filmdicke eines Musters zur Korrektur durchführt, dessen Filmdicke bekannt ist, die unter Verwendung der Lichtquelle und des Lichtempfangselements, die in zumindest einem Messungsschritt und synchron mit der Messung der Filmdicke durch den zumindest einen Messungsschritt ausgeführt wird.

18. Verfahren nach Anspruch 16, wobei die in dem zweiten Messungsschritt gemessenen Filmdickeninformation eine Filmdickendifferenz oder ein Durchschnittswert der Filmdicke ist.

19. Verfahren nach Anspruch 16, wobei der Steuerungsschritt ein Polieren stoppt, wenn die Filmdickenverteilung der Filmschicht in einen vorab eingestellten Bereich gelangt.

20. Verfahren nach Anspruch 16, wobei Vorgänge des ersten Messungsschritts und des zweiten Messungsschritts, des Filmdickenverteilungs-Messungsschritts sowie des Steuerungsschritts während eines Polierens einer Oberfläche der Filmschicht durch die Poliereinrichtung durchgeführt werden.

21. Verfahren nach Anspruch 16, wobei eine gemeinsame Lichtquelle als die Lichtquelle und als die zweite Lichtquelle verwendet wird.

## Revendications

1. Appareil pour mesurer l'épaisseur d'une couche (5a) d'un film se trouvant sur une surface d'un substrat (5b), comportant :
un système (8, 9, 10, 11) de détection de position destiné à détecter une position prédéterminée (A) sur une surface de ladite couche du film ; et
un premier système de mesure (2a) ayant une source de lumière (101) émettant une lumière momentanée et un élément (110) de réception de lumière, ledit premier système de mesure appliquant la lumière momentanée depuis ladite source de lumière à ladite position prédéterminée sur la base d'une détection par ledit système de détection de position, et détectant le faisceau lumineux provenant de ladite position prédéterminée par ledit élément de réception de lumière pour mesurer ainsi une épaisseur de film dans ladite position prédéterminée ;
**caractérisé en ce que** ledit élément (110) de réception de lumière détecte une première réflexion provenant de ladite surface de ladite couche (5a) du film et détecte une seconde réflexion provenant d'une surface limite entre ladite couche (5a) du film et ledit substrat (5b), grâce à quoi l'épaisseur du film dans ladite position prédéterminée (A) est obtenue à partir de franges d'interférence formées par lesdites première et seconde réflexions.

2. Appareil pour polir une surface d'une couche (5a) d'un film se trouvant sur une surface d'un substrat (5b) en utilisant l'appareil de la revendication 1, comportant :
un moyen de polissage (4) entraîné par rapport audit substrat pour ainsi le polir ; et
un système de commande (3) destiné à commander ledit moyen de polissage en utilisant des données obtenues par ledit premier système de mesure.

3. Appareil selon la revendication 2, dans lequel ledit premier système de mesure (2a) comporte un moyen de correction (2c) destiné à corriger une valeur de ladite épaisseur mesurée du film, et ledit moyen de correction effectue une mesure d'une épaisseur du film d'un échantillon pour une correction dont l'épaisseur du film est connue, exécutée en utilisant ladite première source de lumière et ledit premier élément de réception de lumière et en synchronisme avec une mesure de l'épaisseur du film dans ladite position prédéterminée.

4. Appareil selon la revendication 2, dans lequel ledit système de commande arrête le polissage lorsqu'au moins l'une de ladite épaisseur du film et de ladite distribution d'épaisseur du film de ladite couche du film arrive dans une plage préétablie.

5. Appareil selon la revendication 2, dans lequel des opérations réalisées par ledit premier système de mesure et ledit système de commande sont exécutées pendant le polissage d'une surface de ladite surface du film par ledit moyen de polissage.

6. Appareil selon la revendication 2, comportant en outre :
un second système de mesure (2b) ayant une seconde source de lumière (101) émettant une lumière momentanée et un second élément (116) de réception de lumière, ledit second système de mesure appliquant ladite lumière momentanée depuis ladite seconde source de lumière à une zone (B) comprenant ladite position prédéterminée ou adjacente à celle-ci, et détectant le faisceau lumineux provenant de ladite zone par ledit second élément de réception de lumière pour mesurer ainsi une information d'épaisseur du film de ladite zone ;
une partie de mesure de distribution d'épaisseur de film destinée à obtenir une distribution d'épaisseur de film de ladite couche du film en utilisant des résultats d'une mesure obtenue par ledit premier système de mesure et ledit second système de mesure ;
dans lequel ledit système de commande commande si le polissage par ledit moyen de polissage doit ou non être poursuivi sur la base de données obtenues par ladite partie de mesure de distribution d'épaisseur du film.

7. Appareil selon la revendication 6, dans lequel au moins l'un dudit premier système de mesure (2a) et dudit second système de mesure (2b) comporte un moyen de correction (2c, 2d) pour corriger une valeur de ladite épaisseur mesurée du film, et ledit moyen de correction a la mesure de l'épaisseur du film d'un échantillon pour une correction dont l'épaisseur du film était connue, exécutée en utilisant ladite source de lumière et ledit élément de réception de lumière dudit, au moins un, système de mesure et en synchronisme avec la mesure de l'épaisseur du film par ledit, au moins un, système de mesure.

8. Appareil selon la revendication 6, dans lequel ladite information d'épaisseur du film mesurée par ledit second système de mesure (2b) est une différence d'épaisseur de film ou une valeur moyenne de l'épaisseur du film.

9. Appareil selon la revendication 6, dans lequel ledit système de commande (3) arrête le polissage lorsque la distribution d'épaisseur du film de ladite couche du film arrive dans une plage préétablie.

10. Appareil selon la revendication 6, dans lequel des opérations effectuées par lesdits premier (2a) et second (2b) systèmes de mesure, ladite partie de mesure de distribution d'épaisseur du film et ledit système de commande (3) sont exécutées pendant un polissage d'une surface de ladite couche (5a) de film par ledit moyen de polissage (4).

11. Appareil selon la revendication 6, dans lequel une source de lumière commune (101) est prévue en tant que ladite source de lumière (101) et en tant que ladite seconde source de lumière (101).

12. Procédé de polissage pour polir une surface d'une couche d'un film se trouvant sur une surface d'un substrat par un moyen de polissage entraîné par rapport au substrat, comprenant :
une étape de détection de position consistant à détecter une position prédéterminée sur une surface de ladite couche du film ;
une première étape de mesure consistant à appliquer une lumière momentanée à partir d'une première source de lumière à ladite position prédéterminée et à détecter un faisceau lumineux provenant de ladite position prédéterminée par un premier élément de réception de lumière pour mesurer ainsi une épaisseur de film dans ladite position prédéterminée ; et
une étape de commande consistant à commander une condition de polissage en utilisant des données obtenues à ladite première étape de mesure ;
**caractérisé en ce que** ladite première étape de mesure comprend le fait d'amener ledit élément (110) de réception de lumière à détecter une première réflexion provenant de ladite surface de ladite couche (5a) du film et à détecter une seconde réflexion provenant d'une surface limite entre ladite couche (5a) du film et ledit substrat (5b), et à obtenir l'épaisseur du film dans ladite position prédéterminée (A) à partir de franges d'interférence formées par lesdites première et seconde réflexions.

13. Procédé selon la revendication 12, dans lequel ladite première étape de mesure comprend une étape de correction pour corriger une valeur de l'épaisseur mesurée du film et ladite étape de correction effectue une mesure de l'épaisseur du film d'un échantillon pour une correction dont l'épaisseur du film était connue, exécutée en utilisant ladite première source de lumière et ledit premier élément de réception de lumière utilisés à ladite première étape de mesure et en synchronisme avec ladite première étape de mesure.

14. Procédé selon la revendication 12, dans lequel ladite étape de commande arrête le polissage lorsqu'au moins l'une de l'épaisseur du film et de la distribution d'épaisseur du film de ladite couche du film arrive dans une plage préétablie.

15. Procédé selon la revendication 12, dans lequel des opérations effectuées à ladite première étape de mesure et à ladite étape de commande sont réalisées pendant un polissage d'une surface de ladite couche du film par ledit moyen de polissage.

16. Procédé selon la revendication 12, comprenant en outre :
une seconde étape de mesure consistant à appliquer une lumière momentanée depuis une seconde source de lumière à une zone comprenant ladite position prédéterminée ou adjacente à celle-ci et à détecter le faisceau lumineux provenant de ladite zone par un second élément de réception de lumière pour mesurer ainsi une information d'épaisseur de film de ladite zone ; et
une étape de mesure de distribution d'épaisseur du film consistant à obtenir une distribution d'épaisseur du film de ladite couche du film en utilisant des résultats de mesure obtenus à ladite première étape de mesure et à ladite seconde étape de mesure ;
dans lequel ladite étape de commande commande si ledit polissage doit ou non être poursuivi à partir de données obtenues à ladite étape de mesure de distribution d'épaisseur du film.

17. Procédé selon la revendication 16, dans lequel au moins l'une de ladite première étape de mesure et de ladite seconde étape de mesure comprend une étape de correction pour corriger une valeur de l'épaisseur mesurée du film et ladite étape de correction effectue une mesure d'une épaisseur du film d'un échantillon pour une correction dont l'épaisseur du film était connue, exécutée en utilisant ladite source de lumière et ledit élément de réception de lumière utilisés à ladite, au moins une, étape de mesure et en synchronisme avec ladite, au moins une, étape de mesure.

18. Procédé selon la revendication 16, dans lequel ladite information d'épaisseur du film mesurée à ladite seconde étape de mesure est une différence d'épaisseur de film ou une valeur moyenne de ladite épaisseur du film.

19. Procédé selon la revendication 16, dans lequel ladite étape de commande arrête le polissage lorsque la distribution d'épaisseur du film de ladite couche du film arrive dans une plage préétablie.

20. Procédé selon la revendication 16, dans lequel des opérations desdites première et seconde étapes de mesure, de ladite étape de mesure de distribution d'épaisseur du film et de ladite étape de commande sont exécutées pendant un polissage d'une surface de ladite couche du film par ledit moyen de polissage.

21. Procédé selon la revendication 16, dans lequel une source de lumière commune est utilisée en tant que ladite source de lumière et que ladite seconde source de lumière.
